(19) Europäisches Patentamt
European Patent Office
Office européen des brevets

(11) EP 0 354 804 B1

(12) EUROPEAN PATENT SPECIFICATION

(45) Date of publication and mention
of the grant of the patent:
**02.04.1997 Bulletin 1997/14**

(51) Int Cl.6: **H01L 39/22**

(21) Application number: **89308176.0**

(22) Date of filing: **11.08.1989**

(54) **Superconductive transistor**

Supraleitender Transistor

Transistor supraconducteur

(84) Designated Contracting States:
**DE FR GB**

(30) Priority: **11.08.1988 JP 200475/88**

(43) Date of publication of application:
**14.02.1990 Bulletin 1990/07**

(73) Proprietor: **THE FURUKAWA ELECTRIC CO., LTD.**
**Tokyo 100 (JP)**

(72) Inventors:
- **Narumi, Eiki**
  **Morioka-shi Iwate-ken (JP)**
- **Kashiwa, Susumu**
  **Yokohama-shi Kanagawa-ken (JP)**
- **Matsui, Masakazu Rm Nr. 220**
  **Kanagawa-ku Yokohama-shi**
  **Kanagawa-ken (JP)**

(74) Representative: **Gibson, Stewart Harry et al**
**URQUHART-DYKES & LORD,**
**Three Trinity Court,**
**21-27 Newport Road**
**Cardiff CF2 1AA (GB)**

(56) References cited:
**EP-A- 0 218 119          EP-A- 0 324 044**

- **PATENT ABSTRACTS OF JAPAN, vol. 13, no. 121 (E-732)(3469) 24th March 1989 & JP-A-63 289 879**
- **PATENT ABSTRACTS OF JAPAN, vol. 13, no. 26 (E-706)(3374), 20th January 1989 & JP-A-63 228 678**
- **Phys.Rev.Lett., Vol.59(17), 26 October 1987, pp. 1958-1961; Z.Schlesinger et al.: "Superconducting Energy gap and Normal-State Reflectivity of Single Crystal Y-Ba-Cu-O"**
- **Solid State Physics, by N.W.Ashcroft and N.D.Mermin; New York 1976, Holt, Rinehart and Winston; pp. 551 and 744**

**Description**

BACKGROUND OF THE INVENTION

[Field of Invention]

This invention relates to a superconductive transistor having a large capacity for electric current and utilizing the electric field effect.

[Prior Art]

In the field of semiconductors, thyristors, GTO-thyristors, power transistors, power MOSFETs and similar devices are popularly used for quick switch of large electric currents.

While such devices as thyristors, GTO-thyristors and power transistors are available for currents up to 1KA, they are accompanied by the drawback of large electric loss or heat generation whenever they are activated. Besides, they are normally slow for switching, requiring some 30 $\mu$ seconds.

On the other hand, although power MOSFETs are very quick, requiring only 0.1 $\mu$ second for switching, they show a large resistance when activated and hence can not be used for large currents, making themselves only good for electric currents up to several Amps.

In the current trend of technological advancement, development of new switching devices are expected to accommodate large current, high speed switching, minimized loss of electrical power during use, complete shut-out of electric current once deactivated and other requirements.

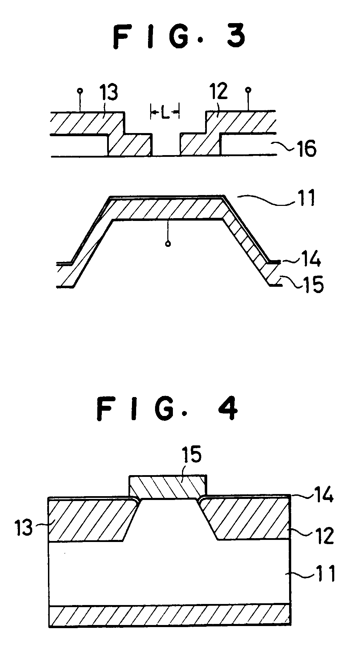

Figs. 3 through 6 of the accompanying drawings show some examples of the devices that have been developed to meet these requirements.

Fig. 3 shows a known device comprising an n-type semiconductor 11 made of n-InSb or n-InAs, on which a source electrode 12 and a drain electrode 13, both being made of an In showing superconductive properties, are juxtaposed with a space L, equal to the coherence length (e.g. 0.5$\mu$m), provided therebetween, an A1 gate electrode 15 being provided below said semiconductor 11 with an insulating layer 14 inserted therebetween and said insulator 14 being made of $SiO_2$ or $Si_3N_4$, and an insulating layer 16 made of the same material as that of said insulating layer 14 being arranged between said semiconductor layer 11 and said juxtaposed electrodes 12 and 13 for electrically insulating them from each other.

With a device as illustrated in Fig. 3, when no voltage is applied to the gate electrode 15, the source electrode 12 and the drain electrode 13 become active with zero resistance due to the proximity effect. On the other hand, when voltage is applied to the gate electrode 15, the source electrode 12 as well as the drain electrode 13 are made inactive with high resistance by modifying the carrier density of the semiconductor between the source and drain electrodes 12, 13 and consequently modifying the coherence length.

Fig. 4 shows a device, which is similar to that of Fig. 3 but comprises a gate electrode 15 arranged on the side of a semiconductor 11 where a source electrode 12 and a drain electrode 13 are provided.

The device of Fig. 4 essentially functions in the same manner as the device of Fig. 3.

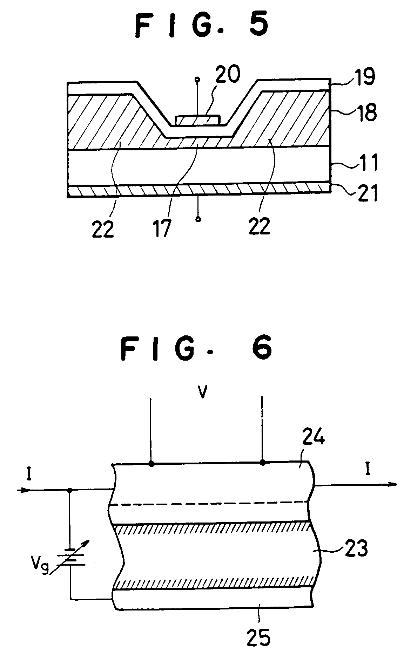

Fig. 5 illustrates a device comprising a semiconductor 11, on which a superconductor layer 18 having a notch (notched portion 17) is placed, an upper electrode 20 being arranged on said notch 17 with an insulator layer provided therebetween and a lower electrode 21 being arranged under said semiconductor 11.

With a device as illustrated in Fig. 5, since the superconductivity of the notched portion 17 (of the superconductor) is nullified under the influence of carrier density modulation of the semiconductor layer due to the proximity effect of a normal state into a superconducting state, the electric conductivity of the device can be controlled by the voltage applied to the upper and lower electrodes 20 and 21.

Fig. 6 illustrates a device comprising an MgO dielectric layer 23 having a thickness of 10nm (100Å), an $In/InO_x$ superconductor layer 24 having a thickness of 4nm (40Å) and an A1 gate electrode 25 being formed respectively on and under said dielectric layer 23.

Contrary to the devices of Figs. 3 through 5, the device of Fig. 6 is free from the requirement of a space equal to the coherence length between the superconductor members, since it does not utilize the proximity effect.

[Problems to be Solved by the Invention]

The above described known devices are still on the way of technological development and accompanied by the following problems to be solved.

While the devices of Figs. 3 through 5 have a quick On/Off function, they can not cope with a large electric current, since the current to be controlled by these devices is either the tunnel current or the Josephson current.

Apart from this, the superconductor members of each of the devices have to be separated by the coherence length and therefore preparation of such a device requires fine precision etching and fabrication processes.

It should be noted when an oxide superconductor is involved, the coherence length can be one-tenth to one-hundredth of that of a metal superconductor, requiring micropatterning that deals with less than 10nm (100Å), a process which is by no means easy.

In principle, the device illustrated in Fig. 6 resembles a field-effect transistor using a semiconductor and hence the charge density of the depletion region that can be injected into the superconductor layer should be roughly equivalent to the carrier density of the superconductor layer. This allows the use of only low carrier density superconductive materials such as $In-InO_x$ and by turn the critical temperature for the use of the superconductor layer will become inevitably very low.

In other words, the maximum temperature at which the device normally functions will become very low, probably lower than the temperature of liquid helium (4.2°K), making the device practically infeasible.

Moreover, the requirement of low carrier density necessarily entails reduction of the critical current density of the superconductor layer, making the device incapable of switching large electric current.

Any attempt to increase the charge density of the depletion region of the device of Fig. 6 can result in break down of the insulator layer, reduction of applicable gate voltage, reduction of the charge injected into the depletion region and other unfavorable characteristics, because a low carrier density superconductive material such as $In-InO_x$ comprises a mixture of $\alpha$-In and crystalline $InO_x$ and does not accept any high-quality insulator layer (dielectric layer) to be deposited thereon.

EP-A-0324044 discloses a superconductive transistor comprising a substrate, an oxide superconductor layer epitaxially grown on said substrate, a source electrode and a drain electrode disposed on said oxide superconductor layer, an insulator film grown on said oxide superconductor layer and located between said source and drain electrodes, and a gate electrode disposed on said insulator film, the thickness of the oxide superconductor layer being such that the superconductive channel can be completely depleted by applying a suitable gate voltage V being smaller than a critical voltage $V_f$ so as to avoid the formation of an inversion layer on the surface of the superconductor layer.

The insulator film is grown by a chemical vapour deposition (CVD) process.

It is an object of the present invention to provide a superconductive transistor of the above-mentioned type having a large capacity for electric current and utilizing the electric field effect for directly controlling majority carriers in the superconductor channel instead of controlling minority carriers due to the Josephson effect and proximity effect, and allowing an easy fabrication process.

Thus, the superconductive transistor in accordance with this invention is characterised in that the insulator film is epitaxially grown on said oxide superconductor layer.

With a conventional field-effect transistor, the electric current is normally controlled by electrostatically modifying the conductivity of the electric path by the third electrode(s) (gate electrodes). Contrary to this, with a superconductive transistor according to this invention, the conductivity of the super-conductor layer is modified by the electrode provided on the insulator film that covers the superconductor layer.

In order to make this arrangement feasible, conditions under which a depletion region is formed in the superconductor layer, through utilization of the field effect, should be determined. Now how to determine these conditions will be described below.

The gate voltage applied to a superconductive transistor is actually divided into two portions; a portion of the voltage applied to the insulator film and the portion applied to the superconductor layer.

When the applied gate voltage is V, the dielectric constant of the superconductor layer is $\varepsilon$ and the carrier density (times the charge per carrier) is n, the thickness of the depletion region in the superconductor layer is given by the following equation:

$$d = \sqrt{(2\varepsilon V)/n} \qquad I$$

If the applied gate voltage V exceeds a critical voltage $V_f$, an inversion layer is formed on the surface of the superconductor layer and an inversion charge (a thin layer of electrons) appears. To avoid this phenomenon, the value V of the voltage applied to the gate should be kept smaller than the critical voltage value $V_f$.

Thus, in order to make the superconductive channel completely depleted, the thickness $d_c$ of the superconductor layer should satisfy equation II below. To obtain a large thickness $d_c$ for the superconductor layer, preferably a superconductive material having a low carrier density is used.

$$d_c \leq \sqrt{(2\varepsilon V_f)/n} \dots\dots\dots\dots\dots\dots II$$

For reference, the voltage $V_f$ of an oxide superconductor such as YBaCuO is approximately 3eV. If its dielectric constant is assumed to be $20\varepsilon_o$, its value that corresponds to that of perovskite crystal being similar to oxide superconductor crystal structure and its carrier density is $10^{21}/cm^3$, $d_c$ will be less than 2.5nm (25Å).

The above value of $d_c$ can be doubled, if the relationship expressed by equation III below is met and a pair of gate electrodes are provided, respectively on and below the superconductor layer.

$$d_c \leq 2\sqrt{(2\varepsilon V_f) / n} \quad \ldots\ldots\ldots\ldots\ldots\ldots\ldots III$$

A superconductive transistor according to the invention comprises an oxide superconductor layer having a high critical temperature and a low carrier density as well as a high critical current density and other desirable characteristics.

Because the superconductive transistor according to an embodiment of the invention is realized in the form of a laminate of insulator layer-superconductor layer-insulator film, i.e. a three-layered planar structure, it can be prepared without micropatterning or fine precision fabrication processes.

Because the three-layered structure is epitaxially grown, the superconductor layer will have a high critical current density. Moreover, it will exhibit a large breakdown voltage and a depletion region will be effectively generated because of clear interface between an insulator film and the superconductor layer.

The net effect of such a structure is an oxide superconductor layer having an excellent electric field effect.

It should be emphasized that the thickness of the superconductor layer should satisfy the above equations II and III in order for the superconductive transistor according to this invention to function as a switching device.

Since the whole current transmitted by the superconductive transistor according to the invention is superconducting transport current, the transistor functions as a switch that can accommodate electric current far greater than the known devices as illustrated in Figs. 3 and 4.

Now the present invention will be described in greater detail by referring to a preferred embodiment of the invention.

## BRIEF DESCRIPTION OF THE DRAWINGS

Fig. 1 is a sectional view of an embodiment of the invention,

Fig. 2 is a graphic illustration showing the characteristics of the embodiment of Fig. 1, and

Figs. 3 through 6 are sectional views of so many different known superconductive transistors.

## DETAILED DESCRIPTION OF THE INVENTION

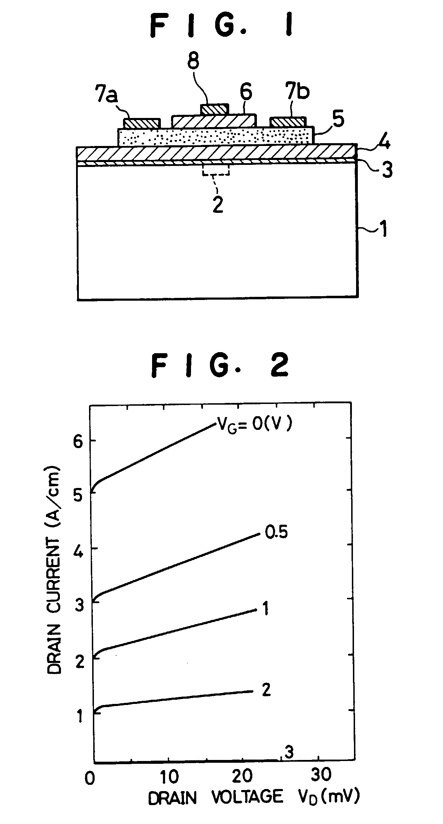

Referring to Fig. 1 which illustrates a sectional view of an embodiment of the invention, a lower gate 2 of n-type Si having a thickness of less then $1\mu m$ is formed by ion implantation on the upper surface of a substrate 1 made of p-type Si.

On the upper surface of said p-type Si substrate 1, on which said lower gate 2 is arranged, a buffer insulator layer 3 of $MgAl_2O_4$ is epitaxially grown with a view to lattice matching. A lower gate insulator film 4 of $SrTiO_3$ is epitaxially grown on said buffer insulator layer 3.

On said lower gate insulator film 4, a superconductor film 5 of $Y_1Ba_2Cu_3O_{6\cdot8}$ is also epitaxially grown. Moreover, an upper gate insulator film 6 of $SrTiO_3$ is formed on said superconductor film 5.

A source electrode 7a and a drain electrode 7b, both made of Ag, are formed on said superconductor film 5 as ohmic contacts and the clearance between these electrodes 7a and 7b provides a predetermined channel length.

A gate electrode 8 is arranged on said upper gate insulator film 6.

A sample superconductive transistor as illustrated in Fig. 1 was prepared in the following way.

To begin with, a lower gate 2 of n-type Si was formed on the upper surface of a p-type (100) Si substrate 1 up to a thickness of $0.25\mu m$ using a P (phosphor) ion implant system.

The energy of the injected P ion was 200kv and its dose was $10^{15}$ ions/$cm^2$. For annealing, the temperature was maintained at 800°C for 30 minutes.

Then, a buffer insulator layer 3 of $MgAl_2O_4$ was epitaxially grown on the p-type Si substrate 1, on which said lower gate 2 had been formed, by means of the CVD technique up to a thickness of 1.5nm (15Å).

During this process, in which aluminum (Al) was heated to 600 to 700°C to react with HCl gas to produce $AlCl_3$ gas, the actual temperature of the aluminum was 650°C. HCl gas was supplied at the rate of 2cc/min, while carrier gas $H_2$ was fed at the rate of 0.5 liter/min.

Thereafter, solid $MgCl_2$ was heated to 800 to 900°C for gasification, the obtained $MgCl_2$ gas being used as source gas.

The heating temperature was actually 840°C and the rate of supply of $H_2$ gas to be used as carrier of $MgCl_2$ gas

was 2 liter/min.

Then using $H_2$ gas as carrier, gaseous $AlCl_2$ and $MgCl_2$ were brought onto said Si substrate 1, which had been heated to 920°C. At the same time, $CO_2$ gas, fed at the rate of 2 to 10cc/min, was supplied onto the heated substrates at the rate of 3cc/min to epitaxially grow a $MgAl_2O_4$ film 3 on said Si substrate 1 according to the following formula;

$$2AlCl_3(g)+MgCl_2(g)+4CO_2(g)+4H_2(g) \rightarrow$$

$$MgAl_2O_4(s)+4CO(g)+8HCl(g)$$

Prior to the formation said film, the natural oxide film that had been formed on said Si substrate was removed by using $H_2$ gas.

Thereafter, a lower gate insulator film 4 of $SrTiO_3$ was epitaxially grown on the upper surface of the buffer insulator layer 3 up to a thickness of 20nm (200Å).

The expitaxial growth of said film 4 was conducted under the condition of gas pressure of 13.3 $N/m^2$ (10m Torr) and substrate temperature of 550°C and in the atmosphere of Ar:$O_2$=4:1 by means of RF magnetron sputtering, using a sintered $SrTiO_3$ piece as target.

Then a superconductor film 5 of $Y_1Ba_2Cu_3O_{6.8}$ was epitaxially grown on said lower gate insulator film 4 up to a thickness of 5nm (50Å) by means of the pulsed LASER deposition technique.

More specifically, a piece of sintered $Y_1Ba_2Cu_3O_{6.8}$ was used as target, while a KrF excimer LASER was used as a LASER source and the target was placed in an atmosphere of $O_2$ gas of 1.33 $N/m^2$ (100m Torr), said target being repeatedly irradiated by the LASER beam from said LASER source with a LASER pulse energy level of 0.2J/shot and the LASER power density of 4$J/cm^2$ at a rate of 10Hz to form said superconductor film 5 on the substrate which had been heated to 600 to 700°C.

For reference, a thin film of YBCO formed to the thickness of 5nm (50Å) on a substrate made of single crystal $SrTiO_3$ will have the characteristics of Tco=81K and JC=$10^5 A/cm^2$ (at 77K).

Then, an upper gate insulator film 6 of $SrTiO_3$ with a thickness of 20nm (200Å) was formed on said superconductor film 5 using the technique as described for the formation of the lower gate insulator film 4.

Finally, a source electrode 7a and a drain electrode 7b made of Ag were ohmically contacted on said superconductor film 5 with a clearance or a channel length of 100μm provided therebetween and a gate electrode 8 was arranged on the upper gate insulator film 6 conforming to a known technique.

The expected epitaxial growth of the films of the above described sample was verified by X-ray analysis and RHEED patterns.

It should be noted that there are restrictions to the thickness of the superconductor layer for a device having a configuration as described above to function as a superconductive transistor.

For instance, when the superconductor film is made of a YBaCuO type material, its thickness is required to be very small, or 2.5nm (25Å) in the above example, making the allowable maximum current (critical current) very low. With such an epitaxial film, the quality of the crystals is often required to meet rigorous standards.

One way to bypass such problems is provision of a structure where the electric channel is sandwiched by an upper gate and a lower gate. With such an arrangement, the critical height of the channel can be doubled.

If the superconductor layer 5 is made of a YBaCuO material, for example, the allowable maximum thickness of the superconductor layer 5 will be 5nm (50Å).

Fig. 2 is a graphic illustration of the characteristics at 77°K of a device prepared on the basis of the above-mentioned principle.

More specifically, Fig. 2 shows the relationship between source-to-drain voltage $V_D$ and drain current $I_D$, using gate voltage $V_G$ as parameter.

As is apparent from Fig. 2, $I_D$ shows its maximum values when $V_G$ is nil and declines as the absolute value of $V_G$ increases in the negative sense, a phenomenon which obviously reveals the switching characteristics of the device.

Some of the results of measurement of the response speed of the device prepared as described above will be shown below.

When the load transistor in the latter stage was driven by the drain current of the driving transistor in the former stage, the switching speed of the device, determined by the charging time of the gate capacity and the inductance of the superconductive channel, was approximately 30nsec, which is considerably shorter than that of a power semiconductor.

The switching current of the device was 20A/cm, which is more than twenty times greater than that of a semiconductor power MOSFET device or 0.8A/cm. This means that the size of a device according to the present invention can be as small as one-twentieth of that of a MOSFET for switching electricity of same level.

While the superconductor layer of the above example is made of a YBaCuO type material, a superconductive transistor comprising a superconductor layer made of a BsSrCaCuO-type material will show similar characteristics.

While the Si substrate can be replaced by a GaAs substrate or an InP substrate, the gate insulator film may be realized by using $ZrO_2$ or $MgAl_2O_4$ with high dielectric constant and high break-down voltage, in place of $SrTiO_3$.

[Effects of the Invention]

As is apparent from the above description, while a superconductive transistor according to the present invention uses an established planar structure and known electrodes, the thickness of the superconductor layer can be made smaller than that of any conventional superconductor, allowing easy manufacture and handling of large current capacity. Moreover, since a superconductive transistor according to the present invention preferably comprises a pair of gate electrodes arranged respectively on and under the superconductor layer, the thickness of the superconductor layer may be increased to stabilize the performance of the transistor.

**Claims**

1. A superconductive transistor comprising a substrate (1), an oxide superconductor layer (5) epitaxially grown on said substrate, a source electrode (7a) and a drain electrode (7b) disposed on said oxide superconductor layer (5), an insulator film (6) grown on said oxide superconductor layer (5) and located between said source and drain electrodes (7a,7b), and a gate electrode (8) disposed on said insulator film (6), the thickness of the oxide superconductor layer (5) being such that the superconductive channel can be completely depleted by applying a suitable gate voltage V being smaller than a critical voltage $V_f$ so as to avoid the formation of an inversion layer on the surface of the superconductor layer (5), <u>characterised in that</u> the insulator film (6) is epitaxially grown on said oxide superconductor layer (5).

2. A superconductive transistor as claimed in claim 1, <u>characterised in that</u> it further comprises a lower insulator film (4) epitaxially grown on said substrate (1) and having said oxide superconductor layer (5) epitaxially grown thereon, and a lower gate electrode (2) located under said lower insulator film (4) and opposite the first-mentioned gate electrode (8).

**Patentansprüche**

1. Supraleitender Transistor, der ein Substrat (1), eine supraleitende Oxidschicht (5), die epitaxial auf das Substrat aufgewachsen ist, eine Source-Elektrode (7a) und eine Drain-Elektrode (7b), die auf der supraleitenden Oxidschicht (5) angeordnet sind, eine Isolatorschicht (6), die auf der supraleitenden Oxidschicht (5) aufgewachsen ist und zwischen den Source- und Drain-Elektroden (7a, 7b) angeordnet ist, und eine Gate-Elektrode (8) aufweist, die auf der Isolatorschicht (6) angeordnet ist, wobei die Dicke der supraleitenden Oxidschicht (5) so ist, daß der supraleitende Kanal völlig durch Anlegen einer geeigneten Gate-Spannung V verarmt werden kann, die kleiner ist als eine kritische Spannung $V_f$, um so die Bildung einer Inversionsschicht auf der Oberfläche der supraleitenden Schicht (5) zu vermeiden, dadurch gekennzeichnet, daß die Isolatorschicht (6) epitaxial auf die supraleitende Oxidschicht (5) aufgewachsen ist.

2. Supraleitender Transistor nach Anspruch 1, dadurch gekennzeichnet, daß er weiter eine untere Isolatorschicht (4), die epitaxial auf das Substrat (1) aufgewachsen ist und auf der die supraleitende Oxidschicht (5) epitaxial aufgewachsen ist, und eine untere Gate-Elektrode (2) aufweist, die unter der unteren Isolatorschicht (4) und gegenüber der erstgenannten Gate-Elektrode (8) angeordnet ist.

**Revendications**

1. Transistor supraconducteur comprenant un substrat (1), une couche d'oxyde supraconductrice (5) mise en croissance épitaxiale sur ledit substrat, une électrode de source (7a) et une électrode de drain (7b) disposées sur ladite couche d'oxyde supraconductrice (5), un film isolant (6) mis en croissance sur ladite couche d'oxyde supraconductrice (5) et situé entre lesdites électrodes de source et de drain (7a, 7b), et une électrode de grille (8) disposée sur ledit film isolant (6), l'épaisseur de la couche d'oxyde supraconductrice (5) étant telle que le canal supraconducteur peut être complètement appauvri en appliquant une tension de grille V appropriée inférieure à une tension critique $V_f$ afin d'éviter la formation d'une couche d'inversion sur la surface de la couche supraconductrice (5), caractérisé en ce que le film isolant (6) est mis en croissance épitaxiale sur ladite couche d'oxyde supraconductrice (5).

2. Transistor supraconducteur selon la revendication 1, caractérisé en ce qu'il comprend en outre un film isolant inférieur (4) mis en croissance épitaxiale sur ledit substrat (1) et sur lequel ladite couche d'oxyde supraconductrice (5) est mise en croissance épitaxiale, et une électrode de grille inférieure (2) située sous ledit film isolant inférieur (4) et à l'opposé de l'électrode de grille (8) mentionnée en premier.

# F I G. 1

# F I G. 2

# F I G . 3

# F I G . 4

# F I G. 5

# F I G. 6